# EUROPEAN PATENT APPLICATION

(11) **EP 4 557 615 A1**
(43) Date of publication of application: **21.05.2025**
(21) Application number: 24209802.8
(22) Date of filing: 30.10.2024
(51) Int. Cl.: H03K 5/151

(54) **DRIVING SIGNAL GENERATING CIRCUIT, HALF-BRIDGE DRIVING CIRCUIT AND LIDAR**

(30) Priority: 14.11.2023 CN 202311519447
(71) Applicant: Suteng Innovation Technology Co., Ltd, Shenzhen City Guangdong 518000 (CN)
(72) Inventor: LIN, Xingkui, Shenzhen (CN); LIU, Jia, Shenzhen (CN)
(74) Representative: Ran, Handong

(57) **Abstract**

The embodiment of the present application discloses a driving signal generating circuit, a half-bridge driving circuit and a LiDAR, wherein the driving signal generating circuit includes a first delay module, a second delay module and an edge obtaining module; an input end of the first delay module is used to obtain an input voltage, and is used to delay the input voltage, and the first delay module is used to control the time of the delayed response of the first driving signal as the dead time; an input end of the second delay module is used to delay the first driving signal and invert it into an inverted control signal; the edge obtaining module is used to determine a second driving signal, which can ensure the charging stability of the load, thereby ensuring the reliability of the use of the LiDAR.

## Description

### TECHNICAL FIELD

The present application relates to the field of LiDAR technology, and in particular to a driving signal generating circuit, a half-bridge driving circuit and a LiDAR.

### BACKGROUND

LiDAR usually uses a half-bridge circuit to charge and discharge a load to complete the light emission and reset. The half-bridge circuit includes a high-side switch and a low-side switch. When the high-side switch is turned on, the load is charged; when the low-side switch is turned on, the load is discharged. However, the high-side switch and the low-side switch may be turned on at the same time, resulting in a short circuit in the circuit and a large current loss. In severe cases, it may cause thermal failure of the high-side switch and the low-side switch, affecting the use of the LiDAR.

In an example, a non-overlapping signal generating circuit is set at the input end of the half-bridge circuit, and a dead time (DT) is inserted between the control signal received by the high-side switch and the control signal received by the low-side switch through the non-overlapping signal generating circuit, so that the high-side switch and the low-side switch will not be turned on at the same time. However, when the dead time is inserted, there may be a loss of the pulse width of the control signal received by the high-side switch, which reduces the charging time and leads to poor reliability of the laser emitted by the LiDAR.

### SUMMARY

Embodiments of the present application provide a driving signal generating circuit, a half-bridge drive circuit and a LiDAR. The driving signal generating circuit can ensure the charging stability of the load, thereby ensuring the reliability of the use of the LiDAR.

In a first aspect, an embodiment of the present application provides a driving signal generating circuit, include a first delay module, a second delay module and an edge obtaining module; an input end of the first delay module is used to obtain the input voltage, and is used to delay the input voltage to obtain a first driving signal, and the first delay module is used to control a time of the delayed response of the first driving signal as a dead time; an input end of the second delay module is connected to an output end of the first delay module, and is used to delay the first driving signal and invert it into an inverted control signal; a first input end of the edge obtaining module is connected to an output end of the second delay module, and the second input end is of the edge obtaining module is used to obtain the input voltage, and is used to determine a second driving signal based on the input voltage and the inverted control signal.

The driving signal generating circuit provided in an embodiment can delay the input voltage to obtain the first driving signal and the second driving signal, and the first driving signal and the second driving signal are not high at the same time, which avoids the half-bridge drive circuit using the driving signal generating circuit to short-circuit, and avoids a large current loss problem. The first delay module is used to delay the input voltage to obtain the first driving signal, and the first delay module can accurately control the dead time of the first driving signal, so that an upper edge and a falling edge of the first driving signal are delayed, and a width of the first driving signal after the delay is consistent with the pulse width of the input voltage, avoiding the problem of signal width loss in the first driving signal after the delay, and ensuring the reliability of charging the load. According to delays and inverts the first driving signal through the second delay module, to obtain an inverted control signal, and determines the edge signal of the second driving signal according to the input voltage and the inverted control signal through the edge obtaining module, and obtains a width of the second driving signal. The width of the second driving signal can be determined based on the distance between the input voltage and the edge signal of the inverted control signal, rather than being determined solely by the level signal of the first driving signal, thereby avoiding the problem that the pulse width of the input voltage is limited by the dead time of the delay of the driving signal generating circuit.

In some possible implementations, the edge obtaining module includes an edge obtaining unit and a latch unit; a first input end of the edge obtaining unit is connected to the output end of the second delay module, and is used for obtaining a rising edge pulse signal of the inverted control signal, and is used for deriving a first edge signal according to the rising edge pulse signal of the inverted control signal; a second input end of the edge obtaining unit is connected to the input voltage, and is used for obtaining a rising edge pulse signal of the input voltage, and is used for deriving a second edge signal according to the rising edge pulse signal of the input voltage; a first input end of the latch unit is connected to a first output end of the edge obtaining unit, and a second input end of the latch unit is connected to a second output end of the edge obtaining unit, and is used for obtaining the second driving signal according to the first edge signal and the second edge signal; wherein the first edge signal and the second edge signal are narrow pulse signals, and the second driving signal is a short pulse signal.

The rising edge pulse signal of the input voltage and the rising edge pulse signal of the inverted control signal can be obtained by the edge obtaining unit, and the first edge signal and the second edge signal are obtained, so as to obtain a width of the second driving signal, that is, a width of the second driving signal is determined by a distance between the edge signal of the input voltage and the inverted control signal, rather than just determined by a level signal of the first driving signal, thereby avoiding the problem that the pulse width of the input voltage is limited by the dead time of the delay of the driving signal generating circuit. The latch unit can determine a second driving signal as a short pulse signal according to the narrow pulse signal of the first edge signal and the second edge signal, so that the second driving signal is a short pulse signal corresponding to the first driving signal.

In some possible implementations, the edge obtaining unit includes a first edge obtaining subunit and a second edge obtaining subunit; an input end of the first edge obtaining subunit is connected to the output end of the second delay module, and an output end of the first edge obtaining subunit is connected to a first input end of the latch unit, and is used for acquiring the rising edge pulse signal of the inverted control signal and generating a first edge signal, which is output to the latch unit; an input end of the second edge obtaining subunit is connected to the input voltage, and an output end is connected to the second input end of the latch unit, and is used for obtaining a rising edge pulse signal of the input voltage and generating a second edge signal, which is output to the latch unit.

In some possible implementations, the first edge obtaining subunit includes multiple first inverters and a first NAND gate, the multiple first inverters are connected in series in sequence and connected in series with the first NAND gate, the first first inverter among the multiple first inverters is connected to the output end of the second delay module, the last first inverter among the multiple first inverters is connected to a first input end of the first NAND gate, a second input end of the first NAND gate is connected to the output end of the second delay module, and an output end of the first NAND gate is connected to the first input end of the latch unit; a quantity of the multiple first inverters connected in series is an odd number.

In some possible implementations, the second edge obtaining subunit includes multiple second inverters and a second NAND gate, the multiple second inverters are connected in series in sequence and connected in series with the second NAND gate, the first second inverter among the multiple second inverters is connected to the input voltage, the last second inverter among the multiple second inverters is connected to a first input end of the second NAND gate, a second input end of the second NAND gate is connected to the input voltage, and an output end of the second NAND gate is connected to a second input end of the latch unit; a quantity of the multiple second inverters connected in series is an odd number.

In some possible implementations, the latch unit includes a first AND gate and a second AND gate; a first input end of the first AND gate is connected to an output end of the first edge obtaining subunit, a second input end of the first AND gate is connected to an output end of the second AND gate, a first input end of the second AND gate is connected to the output end of the second edge obtaining subunit, and a second input end of the second AND gate is connected to an output end of the first AND gate.

In some possible implementations, the first delay module includes a plurality of third inverters connected in series and a first capacitor; the first third inverter among the plurality of third inverters is connected to the input voltage, and an output end of the last third inverter among the plurality of third inverters outputs the first driving signal; one end of the first capacitor is connected to an output end of the last third inverter, and the other end is grounded, and is used for limiting the delay time of the first delay module; a quantity of the plurality of third inverters connected in series is an even number.

A dead time of the first delay module can be set by changing the capacitance of the first capacitor.

In some possible implementations, the second delay module includes a plurality of fourth inverters connected in series and a second capacitor; the first fourth inverter among the plurality of fourth inverters is connected to the output end of the first delay module, and an output end of the last fourth inverter among the plurality of fourth inverters is used to output an inversion control signal; one end of the second capacitor is connected to the output end of the last fourth inverter, and the other end is grounded, and is used for limiting the delay time of the second delay module; a quantity of the plurality of fourth inverters connected in series is an odd number.

A dead time of the second delay module can be set by changing the capacitance of the second capacitor.

In a second aspect, an embodiment of the present application provides a half-bridge drive circuit, comprising a load, the half-bridge drive circuit described, a high-side driving module, and a low-side driving module; an input end of the high-side driving module is connected to a first output end of the driving signal generating circuit, and is used for receiving a first driving signal, and an output end of the high-side driving module is connected to the load, and is used for charging the load according to the first driving signal; an input end of the low-side driving module is connected to a second output end of the driving signal generating circuit, and is used for receiving a second driving signal, and an output end of the low-side driving module is connected to the load, and is used for controlling a discharge of the load according to the second driving signal.

In a third aspect, an embodiment of the present application provides a LiDAR, comprising the half-bridge drive circuit. In a fourth aspect, an embodiment of the present application provides a movable device, comprising a movable main body and the LiDAR, wherein the LiDAR is mounted on the main body.

### BRIEF DESCRIPTION OF DRAWINGS

FIG. 1 is a schematic diagram of a framework structure of a LiDAR;
FIG. 2 is a schematic diagram of a framework structure of a LiDAR;
FIG. 3 is a timing diagram of a first control signal and a second control signal;
FIG. 4 is a schematic diagram of a circuit structure of a signal generating module;
FIG. 5 is a timing diagram of a first control signal and a second control signal;
FIG. 6 is a schematic diagram of a framework structure of a half-bridge drive circuit provided in an embodiment of the present application;
FIG. 7 is a schematic diagram of a framework structure of a driving signal generating circuit provided in an embodiment of the present application;
FIG. 8 is a schematic diagram of a circuit structure of a driving signal generating circuit provided in an embodiment of the present application;
FIG. 9 is a schematic diagram of a circuit structure of a driving signal generating circuit provided in an embodiment of the present application;
FIG. 10 is a schematic diagram of a circuit structure of a driving signal generating circuit provided in an embodiment of the present application;
FIG. 11 is a schematic diagram of a circuit structure of a driving signal generating circuit provided in an embodiment of the present application;
FIG. 12 is a schematic diagram of a circuit structure of a driving signal generating circuit provided in an embodiment of the present application;
FIG. 13 is a schematic diagram of a circuit structure of a driving signal generating circuit provided in an embodiment of the present application;
FIG. 14 is a schematic diagram of a circuit structure of a driving signal generating circuit provided in an embodiment of the present application;
FIG. 15 is a timing diagram provided in an embodiment of the present application;
FIG. 16 is a schematic diagram of a circuit structure of a driving signal generating circuit provided in an embodiment of the present application.

Reference signs:
1. Half-bridge circuit; 11. High-side control module; 12. High-side switch; 13. Low-side control module; 14. Low-side switch; 15. Signal generating module; 151. First inverting module; 152. Second inverting module; 2. Laser; 3. Half-bridge driving circuit; 31. Load; 32. Driving signal generating circuit; 321. First delay module; 322. Second delay module; 323. Edge obtaining module; 3231. Edge obtaining unit; 32311. First edge obtaining subunit; 32312. Second edge obtaining subunit; 33. High-side driving module; 34. Low-side driving module; 3232. Latch unit;
VIN, input voltage; VDC, DC voltage; VDD, operating voltage; GND, ground end; PW, pulse width; DT, dead time; HS, first control signal; LS, second control signal; HO, third control signal; LO, fourth control signal; 32A, first driving signal; 32B, second driving signal; 321A, inverting control signal; 3231A, first edge signal; 3231B, second edge signal; NAND1, first NAND gate; NAND2, second NAND gate; NAND3, third NAND gate; INV1, first inverter; INV2, second inverter; INV3, third inverter; INV4, fourth inverter; INV5, fifth inverter; INV6, sixth inverter; INV7, seventh inverter; C1, first capacitor; C2, second capacitor; NAD1, first AND gate; NAD2, second AND gate.

### DETAILED DESCRIPTION

In order to make the objectives, technical solutions and advantages of the present application more clear, the embodiments of the present application will be further described with reference to the accompanying drawings. Unless otherwise indicated, the same numbers in different drawings represent the same or similar elements. The embodiments described in the following exemplary embodiments do not represent all embodiments.

The terms "first", "second", etc. are used for descriptive purposes only and should not be understood as indicating or implying relative importance. The specific meanings of the above terms in the present application can be understood according to the specific circumstances. Unless otherwise specified, "multiple" refers to two or more. "And/or" describes the association relationship of associated objects, indicating that three relationships may exist. For example, A and/or B can represent: A exists alone, A and B exist at the same time, and B exists alone. The character "/" generally indicates that the previously associated objects are in an "or" relationship. The term "and/or" used herein includes any and all combinations of one or more of the related listed items.

LiDAR: A radar system that uses laser beams to detect the position, speed and other characteristic quantities of a target. It is to emit a detection signal (laser beam) to a target object, and compare the received echo signal reflected from the target object with the detection signal (or local oscillator signal). After processing, relevant information about the target object relative to the Lidar can be obtained, such as distance, direction, height, speed, attitude, or shape parameters.

Half-bridge circuit: based on field effect transistors with switching control functions such as Metal Oxide Semiconductor Field Effect Transistor (MOSFET). The on-time of MOSFET is controlled by pulse width modulation (PWM) signal, so that MOSFET works in high level or low level mode in each cycle.

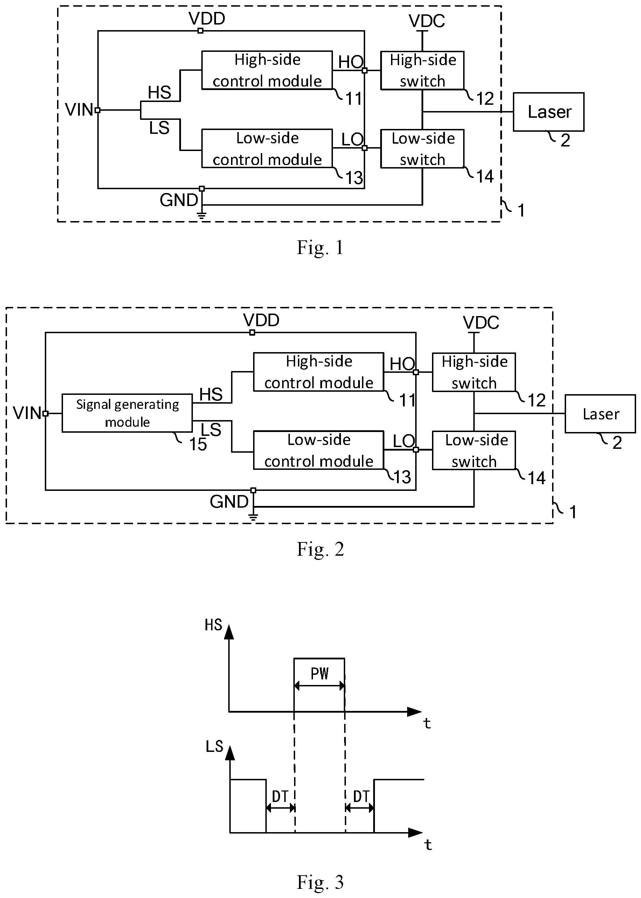

In an example, LiDAR uses a half-bridge circuit to charge and discharge the laser, and complete the light emission and reset of the laser. As shown in FIG. 1, a first end of the half-bridge circuit 1 is used to obtain the input voltage VIN, a second end of the half-bridge circuit 1 is used to obtain the working voltage VDD, and a third end of the half-bridge circuit 1 is connected to a ground end GND. As shown in FIG. 1, the half-bridge circuit 1 can include a high-side control module 11, a high-side switch 12, a low-side control module 13, and a low-side switch 14. The input voltage VIN is used to generate a first control signal HS and a second control signal LS. A first end of the high-side control module 11 is used to obtain the first control signal HS, a first end of the low-side control module 13 is used to obtain the second control signal LS, a second end of the high-side control module 11 is connected to a controlled end of the high-side switch 12, a second end of the low-side control module 13 is connected to a controlled end of the low-side switch 13, a first end of the high-side switch 12 is connected to the DC voltage VDC, a first end of the low-side switch 14 is connected to the ground end GND, and a second end of the high-side switch 12 is connected to the second end of the low-side switch 14 and connected to the laser 2.

The first control signal HS and the second control signal LS generated by the input voltage VIN are used to drive the high-side control module 11 and the low-side control module 13 respectively, so that the high-side control module 11 and the low-side control module 13 respectively generate a third control signal HO and a fourth control signal LO to correspondingly control the on and off of the high-side switch 12 and the low-side switch 14. Exemplarily, when to charge the laser 2, the third control signal HO is at a high level, the high-side switch 12 is turned on, the fourth control signal LO is at a low level, the low-side switch 14 is turned off, and the DC voltage VDC charges the laser 2; when to discharge the laser 2, the third control signal HO is at a low level, the high-side switch 12 is turned off, the fourth control signal LO is at a high level, the low-side switch 14 is turned on, and the laser 2 discharges through the low-side switch 14 .

The first control signal HS and the second control signal LS generated by the signal generating module 11 are usually a high signal and a low signal, and the first control signal HS and the second control signal LS are not at high level at the same time, so that the high side switch 12 and the low side switch 14 are not turned on at the same time, so as to ensure the reliability of the half-bridge circuit 1. However, in some cases, the high side switch 12 and the low side switch 14 may be turned on at the same time, resulting in a short circuit of the half-bridge circuit 1, thereby generating a large current loss problem. In severe cases, it may even cause the high side switch 12 and the low side switch 14 to fail thermally, affecting the reliability of the half-bridge circuit 1, and further affecting the reliability of the LiDAR.

In an example, as shown in FIG. 2, a signal generating module 15 is set at the input end of the half-bridge circuit 1, that is, a signal generating module 15 is set at the input voltage VIN, and the signal generating module 15 is used to adjust the width of the second control signal LS according to the input voltage VIN and the first control signal HS. As shown in FIG. 3, a width of the first control signal HS generated by the signal generating module 15 is same as the pulse width PW of the input voltage VIN, and does not change. The signal generating module 15 can adjust a width of the second control signal LS according to the high level signal of the first control signal HS. Compared with the first control signal HS, the rising edge and falling edge signals of the second control signal LS are delayed by 1 times the dead time DT, so that the high side switch 12 and the low side switch 14 will not be turned on at the same time, so as to avoid the high side switch 12 and the low side switch 14 being turned on at the same time, resulting in a short circuit of the half-bridge circuit 1, and ensuring the reliability of the use of the half-bridge circuit 1. However, as shown in FIG. 3, both the rising edge and the falling edge signals of the second control signal LS are delayed by 1 times the dead time DT, and the pulse width PW of the input voltage VIN needs to be at least greater than 2 times the dead time DT to avoid generating erroneous information. Thus, the pulse width PW of the input voltage VIN is limited by the dead time DT delayed by the signal generating module 15.

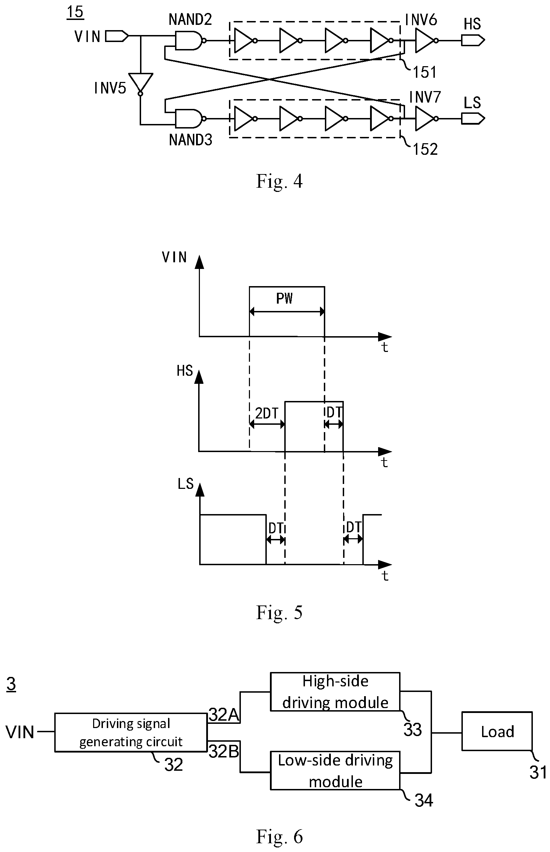

As shown in FIG. 4, the signal generating module 15 may include a second NAND gate NAND2, a third NAND gate NAND3, a fifth inverter INV5, a sixth inverter INV6, a seventh inverter INV7, a first inversion module 151 and a second inversion module 152. A first input end of the second NAND gate NAND2 and one end of the fifth inverter INV5 are used to obtain the input voltage VIN, the other end of the fifth inverter INV5 is connected to a first input end of the third NAND gate NAND3, a second input end of the second NAND gate NAND2 is connected to an output end of the second inversion module 152 and one end of the seventh inverter INV7, a second input end of the third NAND gate NAND3 is connected to the output end of the first inversion module 151 and one end of the sixth inverter INV6, an output end of the second NAND gate NAND2 is connected to the input end of the first inversion module 151, an output end of the third NAND gate NAND3 is connected to input end of the second inversion module 152, the other end of the sixth inverter INV6 is used to output the first control signal HS, and the other end of the seventh inverter INV7 is used to output the second control signal LS.

The first inversion module 151 and the second inversion module 152 respectively include a plurality of inverters connected in series, and a quantity of the plurality of inverters is an even number, so as to delay the signals output by the second NAND gate NAND2 and the third NAND gate NAND3. Exemplarily, as shown in FIG. 5, an input voltage VIN outputs the first control signal HS through the second NAND gate NAND2, the first inversion module 151 and the sixth inverter INV6. Compared with the pulse width PW of the input voltage VIN, a rising edge of the first control signal HS is delayed by 2 times the dead time DT, and a falling edge of the first control signal HS is delayed by 1 times the dead time DT. An input voltage VIN outputs the second control signal LS through the third NAND gate NAND3, the second inversion module 152 and the seventh inverter INV7. Compared with the pulse width PW of the input voltage VIN, the falling edge and the rising edge of the second control signal LS are both delayed by 1 times the dead time DT. In this way, the first control signal HS and the second control signal LS can be delayed respectively through the signal generating module 15, thereby avoiding the problem that the high-side switch 12 and the low-side switch 14 are turned on at the same time, causing the half-bridge circuit 1 to short-circuit, thereby generating a large current loss.

When the dead time DT is inserted between the first control signal HS and the second control signal LS, as shown in FIG. 5, there may be a problem that a width of the first control signal HS received by the high-side switch 12 is less than a pulse width PW of the input voltage VIN, that is, the delayed first control signal HS may have a signal width loss problem, thereby reduce the charging time, resulting in poor reliability of the LiDAR emitting laser. In an example, the rising edge of the first control signal HS is delayed by 2 times the dead time DT, so that the pulse width PW of the input voltage VIN needs to be at least greater than 2 times the dead time DT to avoid generating erroneous information, so that the pulse width PW of the input voltage VIN is limited by the signal generating module 15.

An embodiment of the present application provides a driving signal generating circuit, a half-bridge drive circuit and a LiDAR. The driving signal generating circuit determines the dead time of the first driving signal and the second driving signal through an edge signal, and a rising edge and a falling edge of the first driving signal are delayed by the same time, so that the width of the delayed first driving signal is consistent with the pulse width of the input voltage, thereby ensuring the charging stability of the load and ensuring the reliability of the LiDAR.

As shown in FIG. 6, a half-bridge driving circuit 3 provided in an embodiment may include a load 31, a driving signal generating circuit 32, a high-side driving module 33 and a low-side driving module 34. An input end of the driving signal generating circuit 32 is used to obtain the input voltage VIN, and obtain a first driving signal 32A and a second driving signal 32B according to the input voltage VIN. An input end of the high-side driving module 33 is connected to a first output end of the driving signal generating circuit 32 for obtaining the first driving signal 32A. An output end of the high-side driving module 33 is connected to the load 31. An input end of the low-side driving module 34 is connected to the second output end of the driving signal generating circuit 32 for obtaining the second driving signal 32B. An output end of the low-side driving module 34 is connected to the load 31. A high-side driving module 33 can charge the load 31 according to the first driving signal 32A, and the low-side driving module 34 can control the load 31 to discharge according to the second driving signal 32B, to ensure the reliability of the use of the load 31.

The load 31 may be a laser diode, the high-side driving module 33 controls the laser diode to emit light according to the first driving signal 32A, and the low-side driving module 34 controls the laser diode to reset according to the second driving signal 32B, to ensure the reliability of the laser diode.

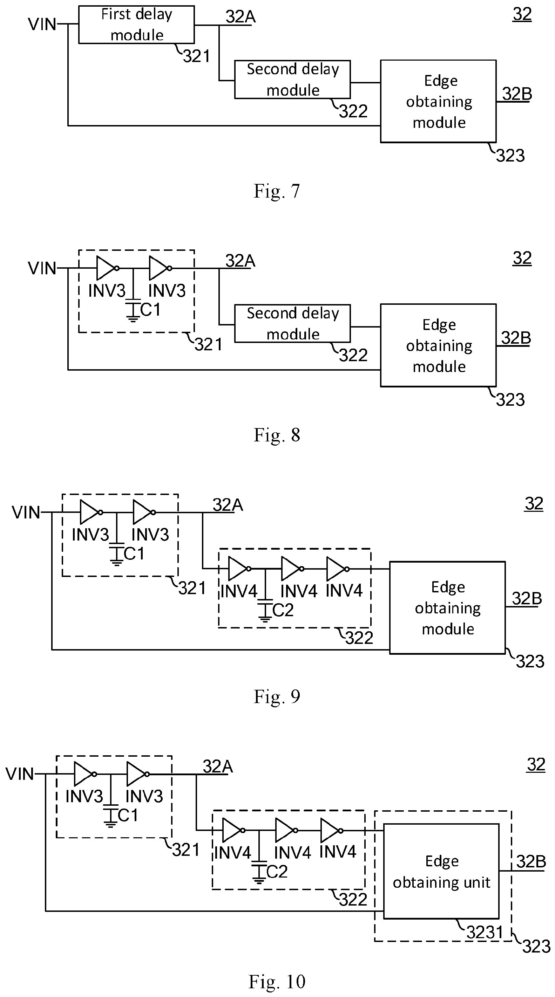

In one example, as shown in FIG. 7, the driving signal generating circuit 32 may include a first delay module 321, a second delay module 322, and an edge obtaining module 323, an input end of the first delay module 321 is used to obtain the input voltage VIN, an input end of the second delay module 322 is connected to an output end of the first delay module 321, a first input end of the edge obtaining module 323 is connected to an output end of the second delay module 322, and a second input end is used to obtain the input voltage VIN.

The first delay module 321 can delay the input voltage VIN to obtain the first driving signal 32A, and the first driving signal 32A is a signal after delay processing. The time for the first delay module 321 to control the delayed response of the first driving signal 32A can be a dead time DT, and the first delay module 321 can set the dead time DT.

In an example, as shown in Figure 8, the first delay module 321 may include a plurality of third inverters INV3 and a first capacitor C1 connected in series in sequence, one end of the first third inverter INV3 among the plurality of third inverters INV3 is connected to the input voltage VIN, the other end of the first third inverter INV3 is connected to an input end of the last third inverter INV3, an output end of the last third inverter INV3 outputs the first driving signal 32A to the high-side driver module 33, one end of the first capacitor C1 is connected to the output end of the last third inverter INV3, the other end of the first capacitor C1 is grounded, and the first capacitor C1 is used to limit the delay time of the first delay module 321, that is, the dead time DT of the first delay module 321 can be set by changing the capacitance of the first capacitor C1.

The first delay module 321 delays the input voltage VIN without inverting, therefore, a quantity of the plurality of third inverters INV3 connected in series is an even number, so that the first driving signal 32A output by the plurality of third inverters INV3 connected in series is the same as the edge signal of the input voltage VIN. In an example, the input voltage VIN is initially an upper edge signal, the first driving signal 32A after delay by the plurality of third inverters INV3 connected in series in sequence is also initially an upper edge signal, so as to ensure the consistency of the first driving signal 32A and the edge signal of the input voltage VIN, and avoid the problem that the edge signals are different and the load 21 cannot be charged normally. FIG. 8 takes the setting of two third inverters INV3 as an example, and a quantity of the third inverters INV3 can be set to other values.

An input end of the second delay module 322 is connected to an output end of the first delay module 321, and is used to delay the first driving signal 32A and invert it into an inverted control signal 321A, that is, the second delay module 322 is used to delay and invert the first driving signal 32A.

In an example, as shown in Figure 9, the second delay module 322 may include a plurality of fourth inverters INV4 and a second capacitor C2 connected in series, the first fourth inverter INV4 among the plurality of fourth inverters INV4 connected in series is connected to an output end of the first delay module 321, an output end of the last fourth inverter INV4 among the plurality of fourth inverters INV4 outputs an inversion control signal 321A, one end of the second capacitor C2 is connected to the output end of the last fourth inverter INV4, the other end of the second capacitor C2 is grounded, and the second capacitor C2 is used to limit the delay time of the second delay module 322, that is, the dead time DT of the second delay module 322 can be set by changing the capacitance of the second capacitor C2.

The second delay module 322 is used to delay and invert the first driving signal 32A, so a quantity of the plurality of fourth inverters INV4 connected in series is an odd number, so that the inverted control signal 321A output by the plurality of fourth inverters INV4 connected in series is different from the edge signal of the first driving signal 32A. In an example, the first driving signal 32A is initially an upper edge signal, the inverted control signal 321A after delay and inversion by the plurality of fourth inverters INV4 connected in series in sequence is initially a falling edge signal. FIG. 9 takes the setting of three fourth inverters INV4 as an example, and a quantity of the fourth inverters INV4 can be set according to other values.

Embodiment of the present application can determine the edge signal of the second driving signal 32B through the edge obtaining module 323, and then obtain a width of the second driving signal 32B. The first input end of the edge obtaining module 323 is connected to the output end of the second delay module 322, and the second input end of the edge obtaining module 323 is used to obtain the input voltage VIN. The edge obtaining module 323 can determine the edge signal of the second driving signal 32B according to the input voltage VIN and the inverted control signal 321A, and obtain the width of the second driving signal 32B.

The driving signal generating circuit 32 in an embodiment of the present application can delay the input voltage VIN, to obtain the first driving signal 32A and the second driving signal 32B, and the first driving signal 32A and the second driving signal 32B are not high at the same time, avoiding the first driving signal 32A and the second driving signal 32B being high at the same time. The input voltage VIN is delayed by the first delay module 321 to obtain the first driving signal 32A, and the first delay module 321 can accurately control the dead time DT of the first driving signal 32A, so that the upper edge and the falling edge of the first driving signal are delayed by the same time, and a width of the delayed first driving signal 32A is consistent with a pulse width PW of the input voltage VIN, avoiding the problem of signal width loss in the delayed first driving signal 32A, and ensuring the reliability of charging the load. According to delay and invert the first driving signal 32A through the second delay module 322, to obtain the inverted control signal 321A, and determines an edge signal of the second driving signal 32B according to the input voltage VIN and the inverted control signal 321A through the edge obtaining module 323, and obtains a width of the second driving signal 32B, that is, the width of the second driving signal 32B can be determined according to the distance between the input voltage VIN and the edge signal of the inverted control signal 321A, rather than being determined solely by the level signal of the first driving signal 32A, avoiding the problem that the pulse width PW of the input voltage VIN is limited by the dead time DT of the delay of the driving signal generating circuit 32.

In order to determine the edge signal of the second driving signal 32B according to the input voltage VIN and the inverted control signal 321A, and obtain a width of the second driving signal 32B, in one example, as shown in FIG. 10, the edge obtaining module 323 may include an edge obtaining unit 3231. A first input end of the edge obtaining unit 3231 is connected to the output end of the second delay module 322, and is used to collect the rising edge pulse signal of the inverted control signal 321A, and obtain the first edge signal 3231A according to the rising edge pulse signal of the inverted control signal 321A. A second input end of the edge obtaining unit 3231 is connected to the input voltage VIN, and is used to collect the rising edge pulse signal of the input voltage VIN, and obtain the second edge signal 3231B according to the rising edge pulse signal of the input voltage VIN. By determining the distance between the input voltage VIN and the rising edge pulse signal of the inverted control signal 321A, a width of the second driving signal 32B is obtained. The first edge signal 3231A and the second edge signal 3231B are two edge signals of the second driving signal 32B.

The edge obtaining unit 3231 can collect the rising edge pulse signals of the input voltage VIN and the inverted control signal 321A, and obtain the first edge signal 3231A and the second edge signal 3231B, thereby obtaining a width of the second driving signal 32B. The width of the second driving signal 32B is determined by the distance between the edge signals of the input voltage VIN and the inverted control signal 321A, rather than being determined solely by the level signal of the first driving signal 32A, thereby avoiding the problem that the pulse width PW of the input voltage VIN is limited by the dead time DT of the delay of the driving signal generating circuit 32.

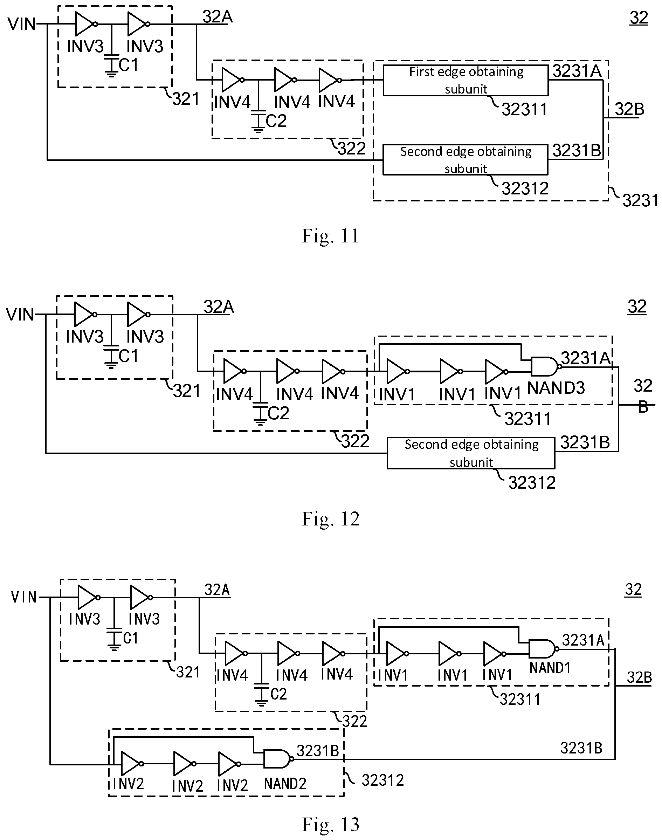

In order to ensure the accuracy of collecting the edge signals of the input voltage VIN and the inverting control signal 321A respectively, in an example, as shown in Figure 11, the edge collection unit 3231 may include a first edge collection sub-unit 32311 and a second edge collection sub-unit 32312, an input end of the first edge collection sub-unit 32311 is connected to an output end of the second delay module 322, the first edge collection sub-unit 32311 can collect the rising edge pulse signal of the inverting control signal 321A and generate a first edge signal 3231A, an input end of the second edge collection sub-unit 32312 is connected to the input voltage VIN, the second edge collection sub-unit 32312 can collect the rising edge pulse signal of the input voltage VIN and generate a second edge signal 3231B, and determine the width of the second driving signal 32B according to the second edge signal 3231B and the second edge signal 3231B. The edge signals of the input voltage VIN and the inverting control signal 321A are collected respectively by the first edge collection subunit 32311 and the second edge collection subunit 32312, thereby ensuring the accuracy of the collection.

In an example, as shown in Figure 12, the first edge obtaining subunit 32311 may include multiple first inverters INV1 and first NAND gates NANA1, the multiple first inverters INV1 are sequentially connected in series and then connected in series with the first NAND gate NANA1, the first first inverter INV1 among the multiple first inverters INV1 is connected to the output end of the second delay module 322, the last first inverter INV1 among the multiple first inverters INV 1 is connected to the first input end of the first NAND gate NANA1, the second input end of the first NAND gate NANA1 is connected to the output end of the second delay module 322, and the output end of the first NAND gate NANA1 is used to output the first edge signal 3231A, wherein a quantity of the multiple first inverters INV1 connected in series is an odd number. The inverted control signal 321A is delayed and inverted by a plurality of first inverters INV1 to obtain an inverted signal of the inverted control signal 321A. The first NAND gate NANA1 obtains a first edge signal 323 1A according to the inverted signal and the inverted control signal 321A.

In an example, as shown in FIG. 13, the second edge obtaining subunit 32312 may include a plurality of second inverters and a second NAND gate NANA2, wherein the plurality of second inverters INV2 are sequentially connected in series and then connected in series with the second NAND gate NANA2, the first second inverter INV2 among the plurality of second inverters INV2 is connected to the input voltage VIN, the last second inverter INV2 among the plurality of second inverters INV2 is connected to the first input end of the second NAND gate NANA2, the second input end of the second NAND gate NANA2 is connected to the input voltage VIN, and the output end of the second NAND gate NANA2 is used to output the second edge signal 3231B, wherein a quantity of the plurality of second inverters INV2 connected in series is an odd number. The input voltage VIN is delayed and inverted by the plurality of second inverters INV2 to obtain an inverted signal of the input voltage VIN, and the second NAND gate NANA2 obtains the second edge signal 3231B according to the inverted signal and the input voltage VIN.

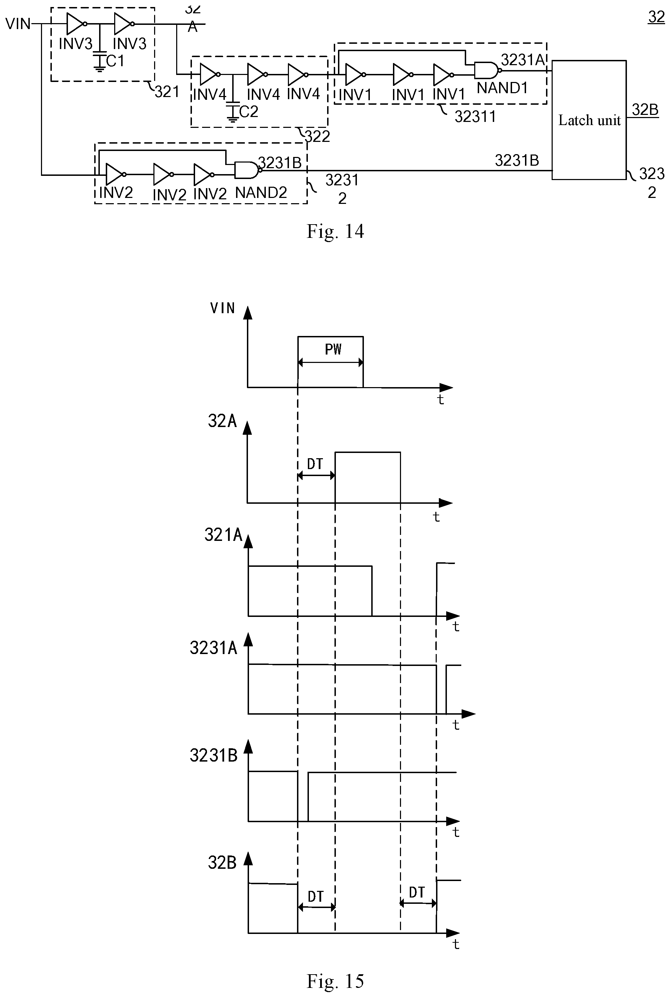

Since the first edge signal 3231A and the second edge signal 3231B obtained by the edge obtaining unit 3231 are narrow pulse signals, and the first driving signal 32A is a short pulse signal, in order to make the second driving signal 32B obtained according to the first edge signal 3231A and the second edge signal 3231B is a short pulse signal, in an example, as shown in Figure 14, the edge obtaining module 323 may include a latch unit 3232, the first input end of the latch unit 3232 is connected to the first output end of the edge obtaining unit 3231, and the second input end of the latch unit 3232 is connected to the second output end of the edge obtaining unit 3231, and the latch unit 3232 is used to determine the narrow pulse signal (that is, the first edge signal 3231A and the second edge signal 3231B) to obtain a short pulse signal (that is, the second driving signal 32B), so that the second driving signal 32B is a short pulse signal corresponding to the first driving signal 32A.

As shown in FIG. 15, it is a timing diagram of the input voltage VIN, the first driving signal 32A, the second driving signal 32B, the inverting control signal 321A, the first edge signal 3231A and the second edge signal 3231B. As can be seen from the figure, compared with the input voltage VIN, the rising edge of the first driving signal 32A and the falling edge of the second driving signal 32B are delayed by 1 times the dead time DT, respectively. Compared with the first driving signal 32A, the rising edge of the second driving signal 32B is delayed by 1 times the dead time DT, so that the first driving signal 32A and the second driving signal 32B are avoided to be high at the same time, resulting in a short circuit of the half-bridge drive circuit 3, thereby generating a large current loss problem, and ensuring the reliability of the half-bridge drive circuit 3.

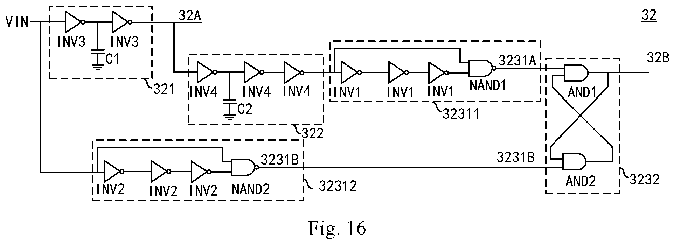

In an example, as shown in Figure 16, the latch unit 3232 may include a first AND gate AND1 and a second AND gate AND2, the first input end of the first AND gate AND1 is connected to the output end of the first edge collection subunit 32311, the second input end of the first AND gate AND1 is connected to the output end of the second AND gate AND2, the first input end of the second AND gate AND2 is connected to the output end of the second edge collection subunit 32312, and the second input end of the second AND gate AND2 is connected to the output end of the first AND gate AND1.

A LiDAR is provided, which includes the half-bridge driving circuit 3 in the above embodiment. It should be noted that technicians can delete, replace or add components in the LiDAR according to actual conditions.

Embodiment of the present application provides a movable device, which includes the LiDAR and a movable device body, and the LiDAR is mounted on the device body. The beneficial effects that can be achieved by the movable device include the beneficial effects that can be achieved by the above LiDAR.

In the embodiments provided in the present application, the disclosed devices can be implemented in other ways. For example, the device embodiments described above are only schematic, for example, the division of modules or units is only a logical function division, and there may be other division methods in actual implementation, such as multiple units or components can be combined or integrated into another device, or some features can be ignored or not executed. The mutual coupling or direct coupling or communication connection shown or discussed can be through some interfaces, indirect coupling or communication connection of devices or units, which can be electrical, mechanical or other forms.

## Claims

1. A driving signal generating circuit, applicable to a LiDAR, wherein the driving signal generating circuit comprises:
a first delay module, wherein an input end of the first delay module is used to obtain an input voltage and delay the input voltage to obtain a first driving signal, and the first delay module is used to control a time of delayed response of the first driving signal to be a dead time;
a second delay module, wherein an input end of the second delay module is connected to an output end of the first delay module and is used to delay the first driving signal and invert the delayed first driving signal into an inverted control signal; and
an edge obtaining module, wherein a first input end of the edge obtaining module is connected to an output end of the second delay module, and a second input end of the edge obtaining module is used to obtain the input voltage and obtain a second driving signal based on the input voltage and the inverted control signal.

2. The driving signal generating circuit according to claim 1, wherein the edge obtaining module comprises:
an edge obtaining unit, wherein a first input end of the edge obtaining unit is connected to the output end of the second delay module, and is used to obtain a rising edge pulse signal of the inverted control signal and obtain a first edge signal according to the rising edge pulse signal of the inverted control signal; and a second input end of the edge obtaining unit is used to obtain the input voltage, obtain the rising edge pulse signal of the input voltage, and obtain a second edge signal according to the rising edge pulse signal of the input voltage; and
a latch unit, wherein a first input end of the latch unit is connected to a first output end of the edge obtaining unit, a second input end of the latch unit is connected to a second output end of the edge obtaining unit and configured to obtain a second driving signal according to the first edge signal and the second edge signal,
wherein the first edge signal and the second edge signal are narrow pulse signals, and the second driving signal is a short pulse signal.

3. The driving signal generating circuit according to claim 2, wherein the edge obtaining unit comprises:
a first edge obtaining subunit, wherein an input end of the first edge obtaining subunit is connected to the output end of the second delay module; and an output end of the first edge obtaining subunit is connected to the first input end of the latch unit, and is used to obtain the rising edge pulse signal of the inverted control signal to generate the first edge signal, and output the first edge signal to the latch unit; and
a second edge obtaining subunit, wherein an input end of the second edge obtaining subunit is used to obtain the input voltage; and an output end of the second edge obtaining subunit is connected to the second input end of the latch unit, and is used to obtain the rising edge pulse signal of the input voltage and generate the second edge signal, and output the second edge signal to the latch unit.

4. The driving signal generating circuit according to claim 3, wherein the first edge obtaining subunit comprises a plurality of first inverters and a first NAND gate, the plurality of first inverters are sequentially connected in series and then connected in series with the first NAND gate, the first first inverter among the plurality of first inverters is connected to the output end of the second delay module, the last first inverter among the plurality of first inverters is connected to a first input end of the first NAND gate, a second input end of the first NAND gate is connected to the output end of the second delay module, and an output end of the first NAND gate is connected to the first input end of the latch unit;
wherein a quantity of the plurality of first inverters connected in series is an odd number.

5. The driving signal generating circuit according to claim 3, wherein the second edge obtaining subunit comprises a plurality of second inverters and a second NAND gate, the plurality of second inverters are sequentially connected in series and then connected in series with the second NAND gate, the first second inverter among the plurality of second inverters is used to obtain the input voltage, the last second inverter among the plurality of second inverters is connected to a first input end of the second NAND gate, a second input end of the second NAND gate is used to obtain the input voltage, and an output end of the second NAND gate is connected to the second input end of the latch unit;
wherein a quantity of the plurality of second inverters connected in series is an odd number.

6. The driving signal generating circuit according to claim 3, wherein the latch unit comprises a first AND gate and a second AND gate; and
a first input end of the first AND gate is connected to the output end of the first edge obtaining subunit, a second input end of the first AND gate is connected to an output end of the second AND gate, a first input end of the second AND gate is connected to the output end of the second edge obtaining subunit, and a second input end of the second AND gate is connected to an output end of the first AND gate.

7. The driving signal generating circuit according to any one of claims 1 to 6, wherein the first delay module comprises:
a plurality of third inverters connected in series in sequence, wherein a first third inverter among the plurality of third inverters is used to obtain the input voltage, and an output end of a last third inverter among the plurality of third inverters is used to output a first driving signal; and
a first capacitor, wherein an end of the first capacitor is connected to the output end of the last third inverter, and the other end of the first capacitor is grounded and is used to limit the delay time of the first delay module,
wherein a quantity of the plurality of third inverters connected in series is an even number.

8. The driving signal generating circuit according to claim 7, wherein the second delay module comprises:
a plurality of fourth inverters connected in series in sequence, wherein a first fourth inverter among the plurality of fourth inverters is connected to the output end of the first delay module, and an output end of a last fourth inverter among the plurality of fourth inverters is used to output an inverting control signal; and
a second capacitor, one end of the second capacitor is connected to the output end of the last fourth inverter, and the other end of the second capacitor is grounded and is used to limit the delay time of the second delay module,
wherein a quantity of the plurality of fourth inverters connected in series is an odd number.

9. A half-bridge driving circuit, comprising:
a load;
a driving signal generating circuit according to any one of claims 1 to 8;
a high-side driving module, wherein an input end of the high-side driving module is connected to the first output end of the driving signal generating circuit, and is used to receive the first driving signal; and an output end of the high-side driving module is connected to the load and is used to charge the load according to the first driving signal; and
a low-side driving module, wherein an input end of the low-side driving module is connected to the second output end of the driving signal generating circuit and is used to receive the second driving signal; and an output end of the low-side driving module is connected to the load and is used to control the load to discharge according to the second driving signal.
